# EUROPEAN PATENT APPLICATION

(11) **EP 4 301 104 A1**
(43) Date of publication of application: **03.01.2024**
(21) Application number: 22182240.6
(22) Date of filing: 30.06.2022
(51) Int. Cl.: H05K 7/20

(54) **ELECTRONIC SYSTEM FOR AN INDUSTRIAL VEHICLE**

(71) Applicant: VOLVO TRUCK CORPORATION, 405 08 Göteborg (SE)
(72) Inventor: RIBERO, Raphaël, 69390 MILLERY (FR); QUIBRIAC, Yann, 69007 LYON (FR)
(74) Representative: Plasseraud IP

(57) **Abstract**

The invention relates to an electronic system (30) for an industrial vehicle (100), comprising :
- A cooling circuit (1) configured for circulating a dielectric coolant fluid,
- A plurality of electronic control modules (2), each electronic control module (2) comprising :
-- an inlet (3) of dielectric coolant fluid,
-- an outlet (4) of dielectric coolant fluid,
-- an electronic board (5) configured to be in direct contact with the dielectric coolant fluid,

in which the electronic control system (30) is configured to circulate dielectric coolant fluid from the inlet (3) to the outlet (4) of each electronic control module (2) so that each electronic board (5) is cooled by the dielectric coolant fluid.

## Description

### Technical Field

This disclosure relates to an electronic system for equipping an industrial vehicle, such as a truck.

### Background Art

Industrial vehicles like trucks are equipped with several electronic systems, such as an engine management system, and a braking/stability control system. Each system comprises at least one electronic control module. These control modules usually dissipate limited electric power, like a few hundred watts. Consequently, keeping these modules at a temperature lower than the maximum temperature can be achieved by simple measures like passive air cooling. With the progressive increase of electric power associated with the latest vehicle generations, combined with the reduction of the space available for receiving the electronic control modules, cooling may require different solutions. Forced air cooling, or circulation of a coolant fluid in a heat exchanger mechanically and thermally coupled with the electronic control module.

As the electric power of hybrid powertrains or fully electric powertrains is largely increased, more heat has to be dissipated by the powertrain controller. Similarly, the control system of an autonomous vehicle requires large calculation power, which means large electrical power. In other words, the traditional methods for managing the electronic control modules temperature may no longer be sufficient.

There is a need of proposing solutions for efficiently cooling the different electronic control modules of an industrial vehicle, while being easy to integrate in the vehicle.

### Summary

To the end, it is proposed an electronic system for an industrial vehicle, comprising :
- A cooling circuit configured for circulating a dielectric coolant fluid,
- A plurality of electronic control modules, each electronic control module comprising :
   -- an inlet of dielectric coolant fluid,
   -- an outlet of dielectric coolant fluid,
   -- an electronic board configured to be in direct contact with the dielectric coolant fluid,
in which the electronic control system is configured to circulate dielectric coolant fluid from the inlet to the outlet of each electronic control module so that each electronic board is cooled by the dielectric coolant fluid.

The heat-dissipating electronic elements of the electronic board are in direct contact with the dielectric coolant fluid, which allows direct heat transfer between the electronic elements and the dielectric coolant fluid. The cooling is particularly effective, which means that electronic control modules with high power can be reliably used.

Direct contact' between the heat-dissipating electronic elements of the electronic board and the dielectric coolant fluid means that the electronic components are wetted by the dielectric coolant fluid.

The following features can optionally be implemented, separately or in combination one with the others:

According to an aspect of the electronic system, each electronic control module is fluid tight.

Each electronic control module comprises a fluid tight casing.

The casing forms a reception chamber for the electronic board. The inlet and the outlet both communicate fluidically with the reception chamber of the electronic board, so that the electronic board is in contact with the dielectric coolant fluid.

The heat generated by the electronic components of the electronic board is dissipated in the dielectric fluid.

The casing of the electronic control modules comprises gaskets and seals configured for sealing the casing.

The dielectric coolant fluid circulates inside the casing of the electronic control modules, in particular in the reception chamber is which the electronic board is housed. The dielectric coolant fluid is electrically insulating. The dielectric fluid can thus be in direct contact with the electronic or electrical components of the electronic control. The dielectric coolant fluid can be diphasic, i.e. comprises a mixture of liquid phase and vapor phase. The dielectric coolant fluid can be monophasic, i.e. completely under liquid phase.

In an embodiment, each electronic control module may comprise several electronic boards configured to be in direct contact with the dielectric coolant fluid.

Each electronic control module is configured for driving and controlling a vehicle subsystem. The subsystem may for example be an electric or hybrid powertrain, or one control module of an autonomous vehicle.

According to an aspect of the electronic system, the cooling circuit is a closed circuit.

In nominal condition, when there's no leakage, the cooling circuit is fluid tight.

The cooling circuit comprises a circulation pump configured for creating a circulation of dielectric coolant fluid.

According to an embodiment, the electronic system comprises a rack, the rack comprising a housing in which the plurality of electronic control modules is received. The cooling circuit is at least partially received in the housing of the rack.

The rack integrates the different electronic control modules, providing a neat installation of the different electronic control modules.

In an embodiment of the electronic system, the cooling circuit comprises a plurality of inlet pipes and a plurality of outlet pipes for circulating dielectric coolant fluid in each electronic control module, and each inlet pipe is at least partially received in the housing of the rack.

In an embodiment, each outlet pipe is at least partially received in the housing of the rack.

The rack may receive at least a portion of the pipes that fluidically connect the electronic control modules to the cooling circuit. The integration in the industrial vehicle is made easier.

In an example of implementation of the electronic system, the electronic control modules extend parallelly from one another in the rack.

This arrangement is space-saving.

The electronic control modules extend in parallel planes. For example, the electronic control modules extend in parallel vertical planes.

In an embodiment, each electronic control module is received in an individual reception chamber of the rack.

In an embodiment of the electronic system, all the electronic control modules are connected in parallel from one another on the cooling circuit.

The cooling circuit comprises several circulation branches arranged in parallel. One electronic control module is disposed on each circulation branch. The cooling circuit comprises as many circulation branches as electronic control modules.

In another embodiment of the electronic system, at least two electronic control modules are connected in series on the cooling circuit.

This arrangement can be more compact and can also be interesting when one of the electronic control modules accepts a higher temperature than another electronic control module.

In that case, an outlet of an electronic control module is directly connected to the inlet of another electronic control module. By "direct connection", it is meant that the portion of circuit connecting the two electronic control modules comprises only one inlet and one outlet.

In an embodiment of the electronic system, the cooling circuit comprises a main valve configured for selectively blocking or allowing a circulation of dielectric coolant fluid in the cooling circuit.

According to an embodiment, the cooling circuit comprises a plurality of individual valves, each individual valve is configured for selectively blocking or allowing a circulation of dielectric coolant fluid in an electronic control module.

Cooling of one individual electronic control module can be inhibited if required by the operation conditions.

In an embodiment of the electronic system, the cooling circuit comprises a plurality of individual valves, each individual valve is configured for controlling a flow of dielectric coolant fluid in an electronic control module between a minimum flow and a maximum flow.

The cooling power provided to each electronic control module can be individually controlled.

The individual valves may be continuously variable valves.

Accurate management of the cooling power provided by each electronic control module can be performed.

The flow of dielectric coolant fluid through the individual valve can vary continuously between a minimum flow and a maximum flow.

The individual valve can be a step valve.

Such valves are usually cheaper than continuously variable valves.

The flow can vary by discrete steps.

In an embodiment, the cooling circuit comprises a principal circulation loop and a plurality of auxiliary branches disposed in parallel of the principal circulation loop, and each electronic control module is disposed on an auxiliary branch.

According to an embodiment, each auxiliary branch comprises a first individual valve disposed upstream of the electronic control module according to a circulation flow of the dielectric coolant fluid.

In an embodiment, each auxiliary branch comprises a second individual valve disposed downstream of the electronic control module according to a circulation flow of the dielectric coolant fluid.

The cooling circuit may thus remain active when one electronic control module is dismantled from the electronic system, for example for the replacement of this electronic control module.

In a variant, at least one auxiliary branch comprises a check valve configured for blocking a dielectric coolant fluid circulation from the principal circulation loop towards the outlet of the electronic control module.

According to an embodiment of the electronic system, the plurality of first individual valves is received in the rack.

In an embodiment, the plurality of second individual valves is received in the rack.

The rack makes the mechanical integration of the components easier.

In an embodiment, each electronic control module is electrically connected to an electrical harness, and each electrical harness is at least partially received in the rack.

Each electrical control module comprises an electrical connector. The harness is electrically connected to the connector.

The rack may comprise a cover configured for closing the housing of the rack.

The rack may have a cuboid shape.

In an embodiment of the electronic system, the cooling circuit comprises a first heat exchanger configured to exchange heat with an air flow.

The air flow can be an air flow exterior to the cabin of the industrial vehicle. The air flow can also be an inside airflow, i.e. an airflow interior to the cabin. This will allow to heat up the ambient temperature inside the cab under cold climate conditions, such as during winter and therefore to reduce HVAC consumption. This is particularly advantageous for Battery Electric Vehicles (BEVs) that cannot benefit from the heat generated by an Internal Combustion Engine (ICE). Accordingly, one option could be to provide a three-way valve having as a first input channel a flow of air coming from the inside of the cab and as a second input channel a flow of air coming from outside the cab. The output channel guides the airflow through the heat exchanger. The idea is then to automatically select the input channel to be connected to output channel as a function of driver request on HVAC system.

The air flow can be an air flow downstream of a cabin evaporator.

The heat transferred from the electronic control modules to the dielectric coolant fluid is in turn dissipated in the airflow.

The electronic system may comprise a cooling fan configured for increasing an airflow over the first heat exchanger.

In another embodiment of the electronic system, the cooling circuit comprises a first heat exchanger configured to exchange heat with a refrigerant fluid.

The electronic system may comprise a refrigerant circuit configured for circulating a refrigerant fluid, the refrigerant circuit comprising sequentially in this order:
- a compressor,
- a second heat exchanger configured for operating as a condenser,
- an expansion valve,
- a first heat exchanger.

The heat transferred from the electronic control modules to the dielectric coolant fluid is then dissipated in the refrigerant fluid, which in turn dissipates this heat at the level of the second heat exchanger. This active cooling may provide large cooling power. The refrigerant circuit may be the same as the one affected to the cooling of the vehicle cabin.

The disclosure also relates to an industrial vehicle, comprising an electronic system as described above.

### Brief Description of Drawings

Other features, details and advantages will be shown in the following detailed description and on the figures, on which:
- Figure 1 is a schematic side view of an industrial vehicle equipped with an electronic system,
- Figure 2 is a schematic view of a first embodiment of an electronic system according to the disclosure,
- Figure 3 is a schematic view of a second embodiment,
- Figure 4 is a schematic view of a third embodiment,
- Figure 5 is a schematic view of a variant of the third embodiment,
- Figure 6 is a schematic side view of an embodiment of the electronic system.

### Description of Embodiments

In order to make the figures easier to read, the various elements are not necessarily represented to scale. In these figures, identical elements receive the same reference number. Certain elements or parameters can be indexed, that is to say designated for example by 'first element' or second element, or first parameter and second parameter, etc. The purpose of this indexing is to differentiate elements or parameters that are similar, but not identical. This indexing does not imply a priority of one element, or one parameter over another, and their names can be interchanged. When it is mentioned that a subsystem comprises a given element, the presence of other elements in this subsystem is not excluded.

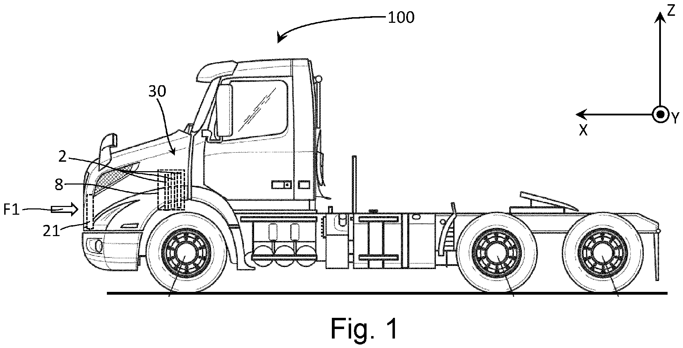

Figure 1 illustrates an industrial vehicle 100, comprising an electronic system 30 that will be described in detail herebelow. The truck may for example be a long-haul truck.

The proposed electronic system 30 for an industrial vehicle 100 comprises :
- A cooling circuit 1 configured for circulating a dielectric coolant fluid,
- A plurality of electronic control modules 2, each electronic control module 2 comprising :
   -- an inlet 3 of dielectric coolant fluid,
   -- an outlet 4 of dielectric coolant fluid,
   -- an electronic board 5 configured to be in direct contact with the dielectric coolant fluid. The electronic control system 30 is configured to circulate dielectric coolant fluid from the inlet 3 to the outlet 4 of each electronic control module 2 so that each electronic board 5 is cooled by the dielectric coolant fluid.

Each electronic control module 2 is configured for driving and controlling a vehicle subsystem 35. The subsystem 35 may for example be an electric or hybrid powertrain, or one control module of an autonomous vehicle. Each electronic control module 2 may handle an electrical power of dozens of watts, for example between 20 watts for simple ECUs up to 100 watts for computational nodes.

The heat-dissipating electronic elements of the electronic board 5 are in direct contact with the dielectric coolant fluid. Direct heat transfer between the electronic elements and the dielectric coolant fluid can therefore take place. The cooling is particularly effective, which means that electronic control modules with high power can be reliably used.

Direct contact' between the heat-dissipating electronic elements of the electronic board 5 and the dielectric coolant fluid means that the electronic components are wetted by the dielectric coolant fluid. The dielectric coolant fluid is electrically insulating. The dielectric coolant fluid may for example in the family of the Perfluorohexan (C6F14) or Perfluorotripentylamine (N(C5F11)3). The dielectric coolant fluid may also be called dielectric cooling fluid.

The cooling circuit 1 is a closed circuit. In nominal condition in which there's no leakage, the cooling circuit 1 is fluid tight. The cooling circuit 1 comprises a circulation pump 10 configured for creating a circulation of dielectric coolant fluid. The cooling circuit 1 also comprises an expansion tank 14. The expansion tank 14 is disposed upstream from the inlet side 10a of the pump 10.

Each electronic control module 2 is fluid tight. Each electronic control module 2 comprises a fluid tight casing 6. The casing 6 of the electronic control modules 2 comprises gaskets and seals configured for sealing the casing 16. These seals and gaskets have not been represented on the figures.

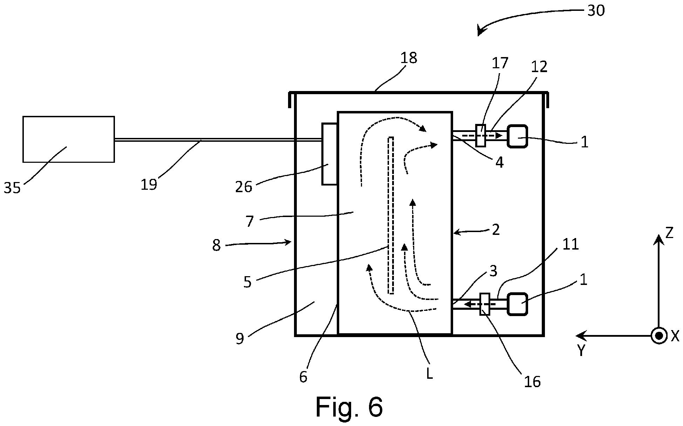

Figure 6 is a schematic side view of the electronic system 30. The casing 6 forms a reception chamber 7 for the electronic board 5. The inlet 3 and the outlet 4 both communicate fluidically with the reception chamber 7 of the electronic board 5, so that the electronic board 5 is in contact with the dielectric coolant fluid.

The heat generated by the electronic components of the electronic board 5 is dissipated in the dielectric fluid.

The dielectric coolant fluid circulates inside the casing 6 of the electronic control modules 2, in particular in the reception chamber 7 is which the electronic board 5 is housed. The arrows in dotted lines, with reference sign L, represent schematically the circulation of the dielectric coolant fluid inside the casing 6 of an electronic control module 2. Coolant flows from the inlet 3 to the outlet 4. On the example of figure 6, the inlet 3 stands at the bottom of the casing 6 along a vertical axis Z, while the outlet 4 stands near the top of the casing 6. The dielectric coolant fluid, which is electrically insulating, can thus be in direct contact with the electronic or electrical components of the electronic control board 5. The dielectric coolant fluid can be diphasic, i.e. comprises a mixture of liquid phase and vapor phase. The dielectric coolant fluid can be monophasic, i.e. completely under liquid phase.

In a non-represented embodiment, each electronic control module 2 may comprise several electronic boards 5 configured to be in direct contact with the dielectric coolant fluid. The different electronic boards are spaced apart so that coolant fluid can flow between two neighboring boards. Both sides of each board are preferably exposed to the dielectric coolant fluid.

The electronic system 30 comprises a rack 8. The rack 8 comprises a housing 9 in which the plurality of electronic control modules 2 is received. The cooling circuit 1 is at least partially received in the housing 9 of the rack 8. The rack 8 integrates the different electronic control modules 2, thus providing a neat installation of the different electronic control modules 2.

As represented on figure 6, the cooling circuit 1 comprises a plurality of inlet pipes 11 and a plurality of outlet pipes 12 for circulating dielectric coolant fluid in each electronic control module 2. Each inlet pipe 11 is here at least partially received in the housing 9 of the rack 8. Similarly, each outlet pipe 12 is at least partially received in the housing 9 of the rack 8. In other words, the rack 8 may receive at least a portion of both inlet and outlets pipes that fluidically connect the electronic control modules 2 to the cooling circuit 1. The integration in the industrial vehicle is made easier. Connection point 28 represents a first interface of the cooling circuit 1 with the rack 8, and connection 29 represents a second interface of the cooling circuit with the rack 8. Connection points 28 and 29 may correspond to an hydraulic connector.

In an example of implementation of the electronic system 30, the electronic control modules 2 extend parallelly from one another in the rack 8. This arrangement saves space for the mechanical integration in the vehicle. The electronic control modules 2 extend in parallel planes. For example, the electronic control modules 2 extend in parallel vertical planes, as schematically represented on figure 1.

On the illustrated example, the different electronic control modules 2 are received in a common reception chamber. In other words, the housing 9 comprises a single reception chamber. In a non-represented embodiment, each electronic control module 2 is received in an individual reception chamber of the rack 8. The housing 9 comprises in that case intermediate walls separating the different chambers. The individual chambers form individual compartments of the casing 6.

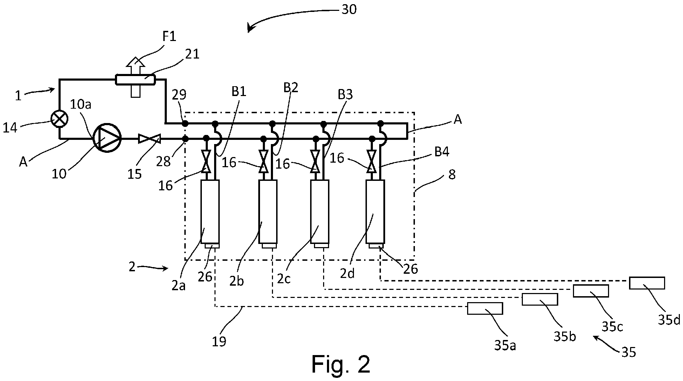

In a first embodiment of the electronic system 30, represented on figure 2, all the electronic control modules 2 are connected in parallel from one another on the cooling circuit 1.

The cooling circuit 1 comprises several circulation branches B1, B2, B3, B4 arranged in parallel. In other words, a portion of circuit linking the outlet of the circulation pump 10 and the inlet of a given electronic control unit does not comprise any other control unit. Similarly, a portion of circuit linking a given electronic control unit and the inlet of the circulation pump 10 does not comprise any other control unit. One electronic control module is disposed on each circulation branch. The cooling circuit 1 comprises as many circulation branches as there are electronic control modules 2. On the illustrated example, the electronic system comprises four electronic control modules identified 2a, 2b, 2c, 2d and four circulation branches referenced B1, B2, B3, B4. Any number is possible, depending on the complexity of the vehicle. On the schematic view, a first subsystem 35a is controlled by a first electronic control module 2a, a second subsystem 35b is controlled by a second electronic control module 2b, a third subsystem 35c is controlled by a third electronic control module 2c and a fourth subsystem 35d is controlled by a fourth electronic control module 2d.

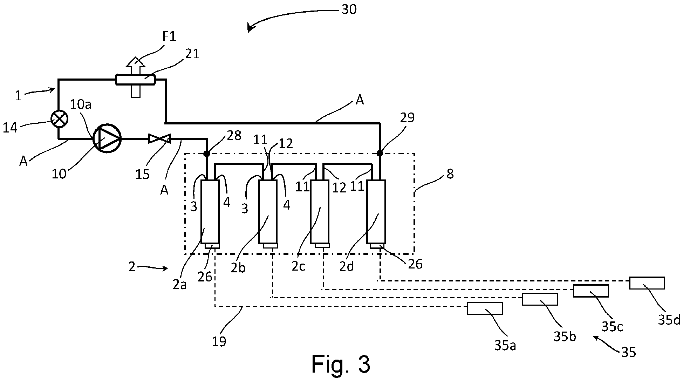

In some embodiments of the electronic system 30, at least two electronic control modules 2 are connected in series on the cooling circuit 1. In a second embodiment, illustrated on figure 3, four electronic control modules referenced 2a, 2b, 2c, 2d are connected in series on the dielectric fluid circuit.

This arrangement can be more compact and can also be interesting when one of the electronic control modules accepts a higher temperature than another electronic control module. In that case the electronic control module that can run hotter than the others is disposed downstream of the control modules that have to run cooler.

In that case, the outlet 4 of a given electronic control module 2 is directly connected to the inlet 3 of another electronic control module 2. By "direct connection", it is meant that the portion of circuit connecting the two electronic control modules comprises only one inlet and one outlet. In non-represented embodiments, some electronic control modules can be connected on the cooling circuit 1 in series and some other control units can be connected in parallel.

In the different illustrated embodiments of the electronic system 30, the cooling circuit 1 comprises a main valve 15 configured for selectively blocking or allowing a circulation of dielectric coolant fluid in the cooling circuit 1.

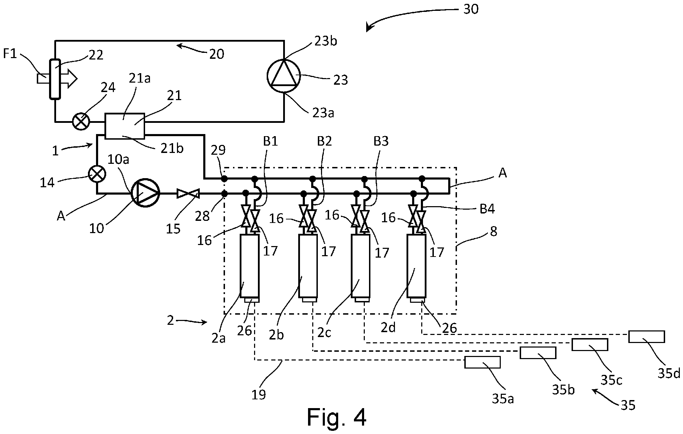

Figure 2 and figure 4 represent embodiments in which the cooling circuit 1 comprises a plurality of individual valves 16. Each individual valve 16 is configured for selectively blocking or allowing a circulation of dielectric coolant fluid in an electronic control module 2.

When an individual valve is shut-off, the cooling of the corresponding electronic control module can be inhibited. Each individual valve may be a two-point valve, i.e a valve with only two stable positions, either fully opened or fully closed.

In an embodiment of the electronic system 30, the cooling circuit 1 comprises a plurality of individual valves 16, with each individual valve configured for controlling a flow of dielectric coolant fluid in an electronic control module 2 between a minimum flow F_min and a maximum flow F_max. The flow of each valve can be adjusted between a minimum flow and a maximum flow. Therefore, the cooling power provided to each electronic control module 2 can be individually controlled, in association with the total flow provided by the circulation pump 10.

The individual valves 16 may be continuously variable valves. The flow of dielectric coolant fluid through the individual valve 16 can thus vary continuously between a minimum flow F_min and a maximum flow F_max. Accurate management of the cooling power provided by each electronic control module 2 can be achieved.

The individual valve 16 can also be a step valve. In that case, the flow through the valve can vary by discrete steps. Such valves are usually cheaper than continuously variable valves. The step valve may for example comprise three different degrees of opening.

The cooling circuit 1 may comprise a mix of continuously variable valve and step valve. The cooling circuit 1 may also comprise a mix of two-point valves and continuously variable valve or step valves.

In the embodiments of figure 2, 4, and 5, the cooling circuit 1 comprises a principal circulation loop A and a plurality of auxiliary branches B1, B2 disposed in parallel of the principal circulation loop A, and each electronic control module 2 is disposed on an auxiliary branch B, B2.

Each auxiliary branch B1, B2 comprises a first individual valve 16 disposed upstream of the electronic control module 2 according to a circulation flow of the dielectric coolant fluid.

In a third embodiment, illustrated on figure 4, each auxiliary branch B1, B2 comprises a second individual valve 17 disposed downstream of the electronic control module 2 according to a circulation flow of the dielectric coolant fluid. The cooling circuit 1 may thus remain active when one electronic control module is dismantled from the electronic system 30, for example during the replacement of this electronic control module. Indeed, the portion of the circuit 1 going in and out the dismantled module may be isolated from the rest of the circuit 1 when the first individual valve 16 and the second individual valve 17 are both in closed position.

It is also possible that only some of the auxiliary branches comprise a second individual valve disposed downstream of the electronic control module according to a circulation flow of the dielectric coolant fluid.

In the variant of the third embodiment, illustrated on figure 4, the circuit 1 comprise only a main valve 15. The auxiliary branches do not receive an individual valve.

In a non-represented variant, at least one auxiliary branch B comprises a check valve configured for blocking a dielectric coolant fluid circulation from the principal circulation loop A towards the outlet 4 of the electronic control module 2.

The plurality of first individual valves 16 is here received in the rack 8. Similarly, the plurality of second individual valves 17 is received in the rack 8. The rack 8 makes the mechanical integration of the components easier. In a non-represented variant, the plurality of first individual valves 16 and the plurality of second individual valves 17 can be disposed outside of the rack 8.

Each electronic control module 2 is electrically connected to an electrical harness 19. Each electrical harness 19 is at least partially received in the rack 8. Each electrical control module 2 comprises an electrical connector 26. The harness 19 is electrically connected to the connector 26.

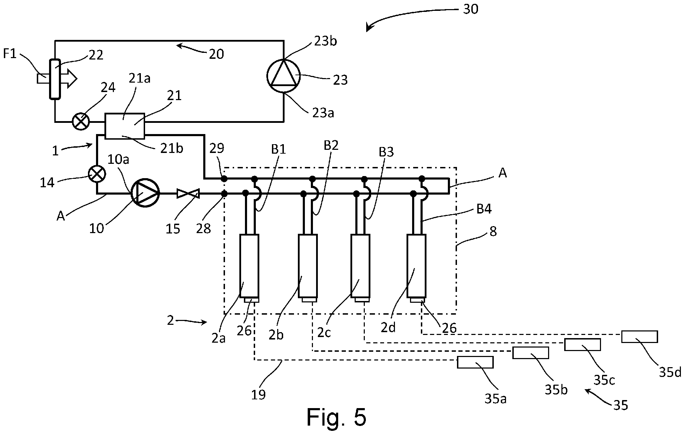

The rack 8 may comprise a cover 18 configured for closing the housing 9 of the rack 8. The cover 8 is illustrated on figure 5. The rack 8 may have a cuboid shape.

The heat transferred to the dielectric coolant fluid may be dissipated in different ways.

In the first and the second embodiments of the electronic system 30, represented respectively on figure 2 and figure 3, the cooling circuit 1 comprises a first heat exchanger 21 configured to exchange heat with an air flow F1.

The air flow F1 can be an air flow exterior to the cabin 50 of the industrial vehicle 100. For example, the first heat exchanger F1 can be located at the front of the truck and receive the air flow resulting from the motion of the vehicle.
The air flow F1 can also be an inside airflow, i.e. an airflow interior to the cabin 50. This will allow to heat up the ambient temperature inside the cabin under cold climate conditions, such as during winter and therefore to reduce the power consumption of the HVAC system. (for "Heating, Ventilating, and Air Conditioning"). This heat recovery is particularly advantageous for Battery Electric Vehicles (BEVs) that cannot benefit from the waste heat generated by an Internal Combustion Engine (ICE). Accordingly, one option can be to provide a three-way valve having as a first input channel a flow of air coming from the inside the cabin and as a second input channel a flow of air coming from outside the cabin. The output channel directs the selected airflow to the first heat exchanger 1. The input channel to be connected to the output channel can be automatically selected in function of the driver request selected on the HVAC system.

The air flow F1 can be an air flow downstream of a cabin evaporator. The heat transferred from the electronic control modules to the dielectric coolant fluid is in turn dissipated in the airflow F1.

The electronic system 30 may comprise a fan configured for increasing an airflow over the first heat exchanger 21. The speed of the fan may be controlled to vary by discrete steps, or to vary continuously.

The expansion tank 14 is disposed between the first heat exchanger 21 and the circulation pump 10. In other words, the expansion tank 14 is disposed downstream from first heat exchanger 21 and upstream from the inlet of the pump 10.

In the third embodiment of the electronic system 30, represented on figure 4, and in its variant represented on figure 5, the cooling circuit 1 comprises a first heat exchanger 21 configured to exchange heat with a refrigerant fluid.

For this, the electronic system 30 comprises a refrigerant circuit 20 configured for circulating a refrigerant fluid, the refrigerant circuit 20 comprising sequentially in this order:
- a compressor 23,
- a second heat exchanger 22 configured for operating as a condenser,
- an expansion valve 24,
- a first heat exchanger 21.

The first heat exchanger 21 comprises a first compartment 21a in which refrigerant fluid can flow and a second compartment 21b in which dielectric cooling can flow. A heat transfer between the two compartments 21a, 21b can take place. The refrigerant enters the compressor inlet 23a in a low-pressure state and is expelled from the compressor outlet 23b in a high pressure, high temperature state. The high-pressure refrigerant out of the compressor 23 is condensed in the second heat exchanger 22. The condensation heat is transferred to the air flow F1. The high-pressure liquid refrigerant out of the second heat exchanger 22 is expanded by the expansion valve 24 and its pressure is decreased to a low-pressure state. The low-pressure refrigerant evaporates in the first compartment 21a of the first heat exchanger 21. The evaporation heat is absorbed from the dielectric coolant fluid in the second compartment 21b, which cools the dielectric coolant fluid. The low pressure vapor out of the first heat exchanger 21 rejoins the inlet 23a of the compressor 23.

This active cooling may provide large cooling power. The cooling power can be controlled at least by the flow of refrigerant and the degree of expansion provided by the expansion valve 24. The refrigerant circuit 20 may be the same as the one of the HVAC system of the vehicle cabin 50. The refrigerant fluid may for example be Perfluorohexan (C6F14) or Perfluorotripentylamine (N(C5F11)3).

In the first and second embodiments, the first heat exchanger 21 is an air/dielectric coolant fluid heat exchanger. In the third embodiment and its variant, the first heat exchanger is a dielectric coolant fluid/ refrigerant heat exchanger, often canned chiller. In the first embodiment and its variant, figures 4 and 5, using active cooling, the expansion tank 14 is disposed in the same manner as in the first and second embodiment, figures 2 and 3, which are based on passive cooling.

## Claims

1. An electronic system (30) for an industrial vehicle (100), comprising :
- a cooling circuit (1) configured for circulating a dielectric coolant fluid,
- a plurality of electronic control modules (2), each electronic control module (2) comprising :
-- an inlet (3) of dielectric coolant fluid,
-- an outlet (4) of dielectric coolant fluid,
-- an electronic board (5) configured to be in direct contact with the dielectric coolant fluid, in which the electronic control system (30) is configured to circulate dielectric coolant fluid from the inlet (3) to the outlet (4) of each electronic control module (2) so that each electronic board (5) is cooled by the dielectric coolant fluid.

2. An electronic system (30) according to claim 1, comprising a rack (8), the rack (8) comprising a housing (9) in which the plurality of electronic control modules (2) is received, in which the cooling circuit (1) is at least partially received in the housing (9) of the rack (8).

3. An electronic system (30) according to the preceding claim, in which the cooling circuit (1) comprises a plurality of inlet pipes (11) and a plurality of outlet pipes (12) for circulating dielectric coolant fluid in each electronic control module (2), and in which each inlet pipe (11) is at least partially received in the housing (9) of the rack (8).

4. An electronic system (30) according to claim 3, in which each outlet pipe (12) is at least partially received in the housing (9) of the rack (8).

5. An electronic system (30) according to any of claims 2 to 4, in which the electronic control modules (2) extends parallelly from one another in the rack (8).

6. An electronic system (30) according to any of claims 1 to 5, in which all the electronic control modules (2) are connected in parallel from one another on the cooling circuit (1).

7. An electronic system (30) according to any of claims 1 to 5, in which at least two electronic control modules (2) are connected in series on the cooling circuit (1).

8. An electronic system (30) according to any of the preceding claims, in which the cooling circuit (1) comprises a main valve (15) configured for selectively blocking or allowing a circulation of dielectric coolant fluid in the cooling circuit (1).

9. An electronic system (30) according to any of the preceding claims, in which the cooling circuit (20) comprises a plurality of individual valves (16), each individual valve (16) being configured for selectively blocking or allowing a circulation of dielectric coolant fluid in an electronic control module (2).

10. An electronic system (30) according to any of the preceding claims, in which the cooling circuit (1) comprises a plurality of individual valves (16), each individual valve being configured for controlling a flow of dielectric coolant fluid in an electronic control module (2) between a minimum flow (F_min) and a maximum flow (F_max).

11. An electronic control system (30) according to any of the preceding claims, in which the cooling circuit (1) comprises a principal circulation loop (A) and a plurality of auxiliary branches (B1, B2) disposed in parallel of the principal circulation loop (A), and in which each electronic control module (2) is disposed on an auxiliary branch (B1, B2).

12. An electronic control system (30) according to the preceding claim, in which each auxiliary branch (B1, B2) comprises a first individual valve (16) disposed upstream of the electronic control module (2) according to a circulation flow of the dielectric coolant fluid.

13. An electronic control system (30) according to claim 11 or 12, in which each auxiliary branch (B) comprises a second individual valve (17) disposed downstream of the electronic control module (2) according to a circulation flow of the dielectric coolant fluid.

14. An electronic system (30) according to the preceding claim, in which the plurality of first individual valves (16) is received in the rack (8), and in which the plurality of second individual valves (17) is received in the rack (8).

15. An industrial vehicle (100), comprising an electronic system (30) according to one of the preceding claims.
